# FASCICULE DE BREVET EUROPEEN

(11) **EP 2 724 390 B1**
(45) Date de publication et mention de la délivrance du brevet: **01.07.2015**
(21) Numéro de dépôt: 12728550.0
(22) Date de dépôt: 19.06.2012
(51) Int. Cl.: H01L 51/44

(54) **PHOTODIODE ORGANIQUE DOTEE D'UNE ZONE ACTIVE COMPORTANT DES MOYENS POUR FAVORISER LA COLLECTE ET LA CONDUCTION DES PORTEURS DE CHARGE**
ORGANISCHE LICHTDIODE MIT EINER AKTIVEN ZONE MIT MITTEL ZUR FÖRDERUNG VON LADUNGSTRÄGERSAMMLUNG UND LEITUNG
ORGANIC PHOTODIODE PROVIDED WITH AN ACTIVE ZONE COMPRISING MEANS FOR PROMOTING CHARGE CARRIER COLLECTION AND CONDUCTION

(30) Priorité: 22.06.2011 FR 1155509
(43) Date de publication de la demande: 30.04.2014
(73) Titulaire: Commissariat à l'Énergie Atomique et aux Énergies Alternatives, 75015 Paris (FR); ISORG, 38000 Grenoble (FR)
(72) Inventeur: BENWADIH, Mohammed, F-94500 Champigny Sur Marne (FR)
(74) Mandataire: Ahner, Philippe
(86) Numéro de dépôt international: PCT/EP2012/061740
(87) Numéro de publication internationale: WO 2012/175512

(56) Documents cités:
- WO-A2-2010/036805
- US-A1- 2008 012 005
- US-A1- 2008 176 030

## Description

### DOMAINE TECHNIQUE

La présente demande concerne le domaine des photodiodes dotées d'une zone active de conversion de photons en excitons, en particulier à base de matériau(x) polymère(s) semi-conducteur, et prévoit une nouvelle structure de photodiode dotée d'une zone active dans laquelle la collection et le transport des porteurs de charge sont améliorés, ainsi qu'un procédé de réalisation d'une telle structure.

### ÉTAT DE LA TECHNIQUE ANTÉRIEURE

Dans les capteurs d'image, les photodiodes sont des composants destinés à convertir des quantités de photons représentatifs de niveaux de luminosité en grandeurs électriques proportionnelles.

Cette conversion est réalisée au niveau d'une zone 2 de la photodiode généralement appelée zone « active » et qui est située entre deux électrodes 4 et 6.

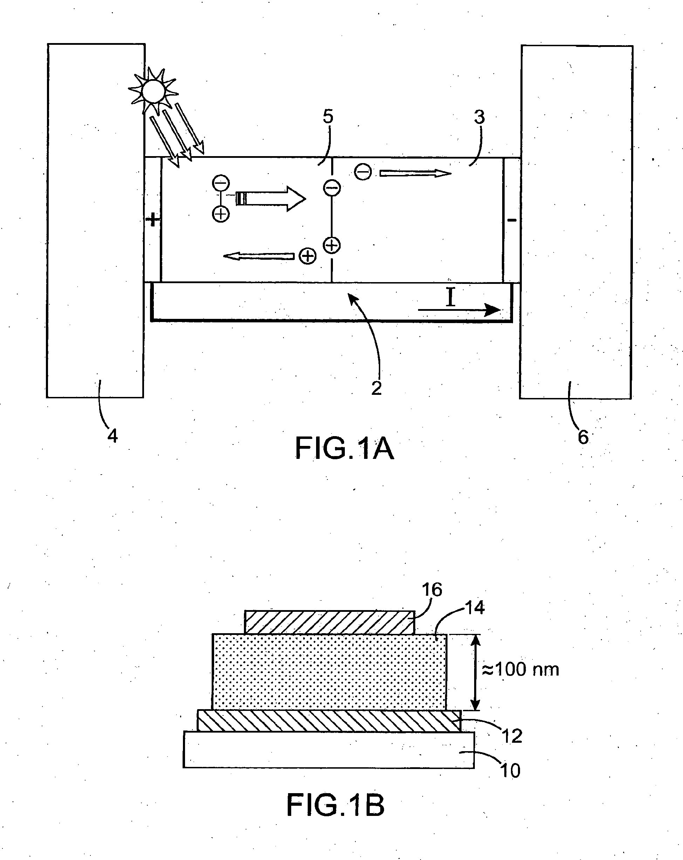

La zone active 2 peut être une jonction de deux régions, une première région 3 à base d'un premier matériau semi-conducteur de type N donneur d'électrons et une deuxième région 5 à base d'un deuxième matériau de type P accepteur d'électrons (figure 1A).

Il existe des photodiodes dont la zone active est formée de matériau(x) semi-conducteur(s) dont la zone active est formée de matériau(x) polymère semi-conducteur.

Il est connu en particulier de former pour ces photodiodes des zones actives 2 à base d'un mélange de polymères comportant au moins un polymère accepteur d'électrons et au moins un polymère donneur d'électrons.

Une interaction de photons avec un tel matériau est susceptible de former des excitons, c'est-à-dire des paires d'électrons trous, qui se séparent pour former un courant électrique.

Sur la figure 1B, un exemple de photodiode organique suivant l'art antérieur est donné. Cette photodiode est formée sur un substrat 10 recouvert d'une anode 12, par exemple à base d'ITO (Indium Tin Oxide) et de PEDOT:PSS, l'anode étant surmontée d'une couche active 12 formée d'un mélange de matériaux polymères comportant un polymère donneur et un matériau polymère accepteur, la couche active 12 étant elle-même surmontée d'une cathode 16.

Avec un tel matériau de couche active, la durée de vie des excitons et la mobilité de porteurs de charges sont faibles. Ainsi, seule une faible proportion des paires électrons-trous générés par les photons contribue effectivement à l'établissement d'un photo-courant.

Le rendement EQE (EQE pour « External Quantum Efficiency ») de conversion photon électrons permet de quantifier les performances du matériau de la couche active 12.

Il se pose le problème de mettre en oeuvre une photodiode à zone active à base de matériau polymère dotée d'un rendement EQE amélioré.

Le document US 2008/012005 A1 divulgue une photodiode comprenant, des couches semiconductrices discontinues.

### EXPOSÉ DE L'INVENTION

L'invention concerne tout d'abord une diode, dotée d'électrodes et entre ces électrodes, d'au moins une zone active formée d'au moins un matériau semi-conducteur donné, la zone active comprenant en outre un ou plusieurs éléments dans le matériau semi-conducteur donné entre les électrodes et prévus à base d'un matériau conducteur ou semi-conducteur différent dudit matériau donné.

Les éléments conducteurs ou semi-conducteurs sont sous forme de zones allongées qui s'étendent entre les électrodes dans le matériau donné de la zone active dans une direction réalisant un angle non-nul avec les électrodes.

La diode peut être une photodiode, en particulier organique, dont la zone active est destinée à générer des excitons suite à une absorption de photons.

Parmi lesdits éléments figurent un ou plusieurs premier (s) élément(s) à base d'un matériau favorisant la conduction de trous.

Parmi lesdites éléments figurent un ou plusieurs deuxième(s) élément(s) à base d'un matériau favorisant la conduction d'électrons.

Les éléments conducteurs ou semi-conducteurs disposés dans le matériau de zone active de la diode permettent d'améliorer le rendement de conversion photon électrons et le prélèvement des charges par les électrodes.

Avec de tels éléments la collecte de charges dans la zone active peut être ainsi améliorée.

Ces éléments peuvent s'étendre en particulier dans une direction orthogonale aux électrodes.

Les éléments conducteurs ou semi-conducteurs sont disposés de manière à ne pas être en contact avec les électrodes.

Les éléments conducteurs ou semi-conducteurs peuvent être prévus sous forme de barreaux ou de pistes oblongues ou allongées.

Avec de tels éléments, le drainage de charge peut être amélioré, en particulier pour des dispositifs ayant une distante importante entre les électrodes, par exemple de l'ordre de plusieurs millimètres.

Avec de tels éléments, le drainage de charges est tout particulièrement amélioré dans les zones actives à base de matériau organique ou polymère semi-conducteur.

Les éléments conducteurs ou semi-conducteurs sont ainsi prévus à base d'un matériau différent de celui des régions de la zone active avec lesquelles ces éléments sont en contact, le matériau des éléments conducteurs favorisant le transport de charges dans la zone active.

Les éléments conducteurs ou semi-conducteurs sont ainsi prévus de manière à présenter une conductivité meilleure que la conductivité du matériau de la zone active, en particulier une conductivité au moins 2 fois supérieure à la conductivité du matériau de la zone active.

Selon un agencement particulier, les éléments conducteurs ou semi-conducteurs peuvent être formés d'un ensemble de pistes agencées en une alternance de pistes favorisant la conduction de troues et de pistes favorisant la conduction des électrons.

On augmente ainsi la surface de la jonction à l'aide d'un réseau donneur/accepteur assurant le transport de trous vers l'anode et des électrons vers la cathode.

Selon une possibilité de mise en oeuvre, les pistes favorisant la conduction de trous et les pistes favorisant la conduction des électrons sont disposées sous forme de peignes interdigités.

Avec un tel agencement, on améliore davantage la collecte et le transport de porteurs vers les électrodes, tout en limitant l'encombrement.

La première électrode peut être destinée à jouer le rôle d'anode tandis que la deuxième électrode est destinée à jouer le rôle de cathode. Dans ce cas, afin de favoriser la collecte de trous, le ou les premiers éléments favorisant la conduction de trous peuvent être alors disposés plus prêt de l'anode que de la cathode.

Selon une possibilité de mise en oeuvre, le ou les éléments favorisant la conduction de trous peuvent être disposés à une distance d₁ de l'anode et à une distance Δ₁ de la cathode, avec d₁/Δ₁ ≤ 10.

Afin de favoriser la collecte d'électrons, les éléments favorisant la conduction des électrons peuvent être disposés plus prêt de la cathode que de l'anode.

Selon une possibilité de mise en oeuvre, le ou les deuxièmes éléments favorisant la conduction des électrons peuvent être disposés à une distance d₂ de la cathode et une distance Δ₂ de l'anode, avec d₂/Δ₂ ≤ 10.

Selon une possibilité de mise en oeuvre, la surface externe totale desdits éléments conducteurs ou semi-conducteurs, susceptible d'être vue par un rayonnement lumineux, peut être prévue au moins 10 fois inférieure à la surface externe de la zone active vue par ce même rayonnement.

On limite ainsi les phénomènes de réflexions parasites.

L'épaisseur des éléments vue par un rayonnement lumineux peut être prévue inférieure ou égale à 100 nanomètres et avantageusement inférieure ou égale à 20 nanomètres.

On limite également de cette manière les phénomènes de réflexions parasites.

Selon une possibilité de mise en oeuvre, lesdits éléments peuvent être à base d'un matériau ambipolaire.

Selon une possibilité de mise en oeuvre, lesdits éléments peuvent être à base d'un matériau ambipolaire ou semi-conducteur prévu de sorte que la mobilité des porteurs de charges dans ce matériau est supérieure, en particulier au moins 2 fois supérieure, à la mobilité des porteurs de charge dans le matériau de la zone active dans lequel lesdits éléments sont disposés.

Le matériau donné peut être un matériau polymère semi-conducteur.

Selon une autre possibilité de mise en oeuvre, lesdits éléments peuvent être à base d'un matériau polymère conducteur.

Selon une autre possibilité de mise en oeuvre, lesdits éléments peuvent être à base d'un métal recouvert d'une couche adaptée pour modifier le travail de sortie dudit métal, telle qu'une couche SAM (SAM pour « self assembled monolayer »).

Selon une possibilité de mise en oeuvre de la diode, parmi lesdits éléments peu(ven)t figurer un ou plusieurs premier(s) élément(s) à base d'un matériau conducteur de type P, choisi parmi les matériaux suivants : Au, ITO, Cu, Ni, Ag, Pd, PEDOT:PSS.

Selon une possibilité de mise en oeuvre de la diode, parmi lesdits éléments peu(ven)t figurer un ou plusieurs deuxième (s) élément(s) à base d'un matériau conducteur de type N, choisi parmi les matériaux suivants : Ca, Al.

Selon une possibilité de mise en oeuvre de la diode, parmi lesdits éléments peuvent également figurer :
- un ou plusieurs premier(s) élément(s) à base d'un métal recouvert d'une couche SAM de type P telle qu'une couche de PFBT ou pentafluorobenzenethiol, et/ou,
- un ou plusieurs premier(s) élément(s) à base d'un métal recouvert d'une couche SAM de type N telle qu'une couche de 4MTP ou méthoxythiolphenol.

Selon une possibilité de mise en oeuvre de la zone active, cette dernière peut être formée d'une première région à base dudit premier matériau polymère et d'une deuxième région accolée à la première région et à base dudit deuxième matériau polymère, au moins un desdits éléments étant à base d'une zone de métal traversant la première région et la deuxième région, la zone de métal étant recouverte dans ladite première région d'une couche adaptée pour augmenter le travail de sortie dudit métal, la zone de métal étant recouverte en outre dans ladite deuxième région d'une couche adaptée pour diminuer le travail de sortie dudit métal.

Selon une possibilité de mise en oeuvre, la zone active du composant est formée d'un mélange d'un premier matériau polymère semi-conducteur donneur d'électrons et d'un deuxième matériau polymère semi-conducteur accepteur d'électrons.

La zone active du composant peut éventuellement être formée d'un mélange d'un matériau polymère semi-conducteur et d'un matériau organique semi-conducteur.

Selon une mise en oeuvre particulière de la diode, la zone active peut être avantageusement formée d'un mélange de PCBM et de P3HT, tandis que parmi lesdits éléments figurent des premiers éléments à base d'Au recouverts d'une couche SAM à base de P3HT, figurent des deuxièmes éléments à base d'Au recouverts d'une couche de 4 MTP.

Selon un aspect de cette mise en oeuvre particulière, la surface externe totale des éléments susceptible d'être vue par un rayonnement lumineux peut être de l'ordre de 20 % de la surface externe de la zone active vue par ce même rayonnement.

La présente invention prévoit également un dispositif microélectronique comprenant au moins une diode telle que définie plus haut dans laquelle lesdits éléments conducteurs sont connectés à une charge extérieure. Cette charge extérieure peut être sous forme d'au moins un condensateur ou de moyens formant un accumulateur, que l'on recharge par le biais d'un courant généré par la diode et circulant au niveau desdits éléments conducteurs ou semi-conducteurs.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A, 1B illustrent un dispositif de photodiode suivant l'art antérieur,
- les figures 2A-2B illustrent un exemple de photodiode suivant l'invention, avec une zone active à base de polymères et dans laquelle des éléments permettent de faciliter la collecte et le transport des porteurs de charges dans cette zone active,
- la figure 3 illustre une variante de mise en oeuvre de photodiode suivant l'invention, dans laquelle des éléments permettant de faciliter la mobilité des porteurs de charges sont disposés dans la zone active et ont une forme en 'U',

- la figure 4 illustre une autre variante de mise en oeuvre de photodiode suivant l'invention, comportant une zone active avec une alternance d'éléments permettant de faciliter la mobilité des électrons et d'éléments permettant de faciliter la mobilité des trous,
- la figure 5 illustre une autre variante de mise en oeuvre de photodiode suivant l'invention, dans laquelle la zone active comporte des éléments permettant de faciliter la collecte et le transport de trous et des éléments permettant de faciliter la collecte et le transport d'électrons, ont une forme de peignes interdigités,
- la figure 6 illustre une variante d'agencement des éléments en forme de peigne de la figure 5,
- la figure 7 illustre une réalisation particulière d'éléments traversant la zone active d'une photodiode suivant l'invention et prévus pour améliorer la mobilité des porteurs de charges dans cette dernière,
- la figure 8 illustre une réalisation en un empilement de couches d'une photodiode organique suivant l'invention,
- la figure 9 illustre un dispositif dans lequel une photodiode mise en oeuvre suivant l'invention dotée de pistes conductrices disposées dans la zone active et favorisant le transport de charges dans cette dernière, permet d'injecter un courant de charge à un dispositif externe connecté auxdites pistes conductrices ou semi-conductrices,
- la figure 10 illustre un autre exemple de photodiode suivant l'invention, avec une zone active dans laquelle des éléments verticaux permettant de faciliter la collecte et le transport trous et dans laquelle des éléments verticaux permettent de faciliter la collecte et le transport électrons.

Des parties identiques, similaires ou équivalentes des différentes figures portent les mêmes références numériques de façon à faciliter le passage d'une figure à l'autre.

Lés différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

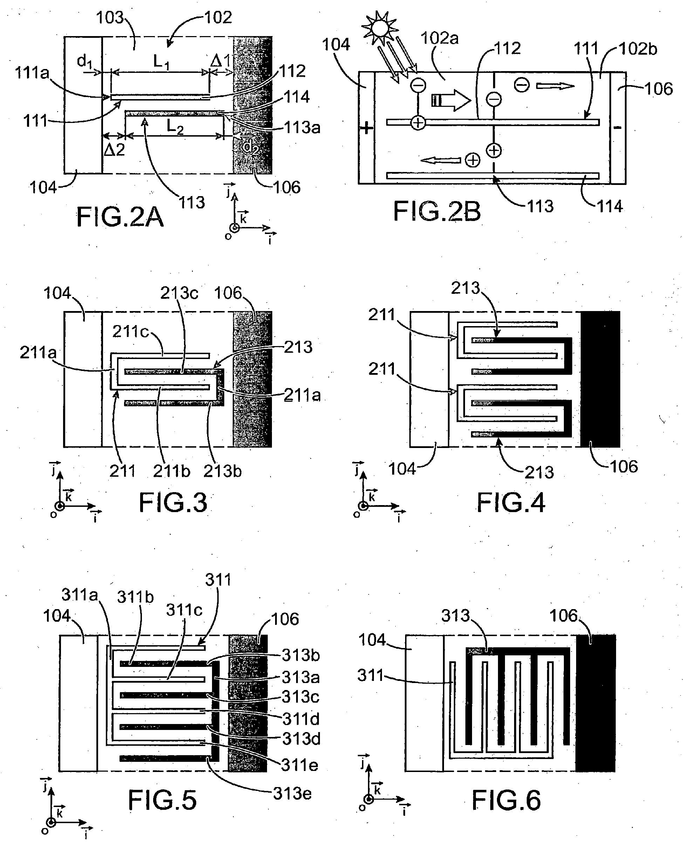

Un exemple de diode suivant l'invention, va à présent être donné en liaison avec les figures 2A-2B et 3.

Cette diode peut être une photodiode comportant une zone 102 dite « zone active » de conversion de photons en excitons, et qui est située entre des électrodes 104 et 106, une première électrode 104 étant destinée à jouer le rôle d'anode, et la deuxième électrode 106 étant destinée à jouer le rôle de cathode.

La cathode 106 peut être par exemple à base d'Al, ou d'Au, ou d'un alliage d'Au et de Ti, ou d'Indium, ou d'un alliage à base de calcium et d'argent, ou d'un composé de 2,9-dimethyl-4,7-diphenyl-1,10-phenanthroline communément appelé BCP et d'argent.

L'anode 104 peut être par exemple à base de Mn, ou de Cr, ou d'Ar, ou d'Indium, ou d'un alliage calcium argent, ou d'un alliage d'or et de Platine, ou d'ITO (ITO pour « Indium tin oxide »).

La zone active 102 est, quant à elle, formée d'au moins un matériau 103 semi-conducteur (s) et peut comprendre au moins un polymère(s) semi-conducteur(s).

Selon une possibilité, le matériau 103 de la zone active 102 peut être formé d'un mélange de polymères comportant au moins un polymère accepteur d'électrons, et au moins un polymère donneur d'électrons (figure 2A).

Selon une autre possibilité (figure 2B), le matériau 103 peut être formé d'une première région 102a formée d'au moins un polymère accepteur d'électrons, et d'une deuxième région 102b, accolée à la première région 102a, et qui est à base d'au moins un polymère donneur d'électrons.

Le matériau polymère 103 peut être un mélange d'un polymère de type P tel que par exemple du poly(3-hexylthiophène) ou poly(3-hexylthiophène-2,5-diyl) et communément appelé « P3HT », et d'un polymère de type N. Le matériau de type N peut être par exemple du [6,6]-phényl-C₆₁-butanoate de méthyle et communément appelé « PCBM » sur lequel peut être greffé un polymère.

Entre les électrodes 104 et 106, des éléments 111, 113 conducteurs ou semi-conducteurs sont prévus dans le matériau 103 de la zone active 102, afin d'améliorer la collecte et la circulation des porteurs de charge.

Les éléments 111, 113 sont prévus en particulier avec un matériau permettant d'améliorer le transport des porteurs de charge dans la zone active et à destination de leurs électrodes 104, 106 respectives.

Ces éléments 111, 113 s'étendent dans le matériau 103 de la zone active 102 et peuvent être prévus sous forme de pistes ou de barreaux avec une forme allongée ou oblongue. On améliore ainsi également la collecte des porteurs de charge dans la zone active et à destination de leurs électrodes 104, 106 respectives.

Un premier élément 111 à base d'un premier matériau 112 favorisant la conduction des trous traverse une partie de la zone active 102 et s'étend dans le sens de sa longueur L₁ (définie dans une direction parallèle au vecteur i du repère orthogonal [*O; i̅; j̅; k̅*] donné sur la figure 2A) entre les électrodes 104 et 106. Le premier élément 111 permet de mettre en oeuvre une collecte plus rapide et plus efficace des trous qu'avec une zone active uniquement à base de matériau 103 et mise en oeuvre suivant l'art antérieur.

Un deuxième élément 113 à base d'un deuxième matériau 114 favorisant la conduction des électrons traverse une partie de la zone active 102 et s'étend dans le sens de sa longueur L₂ (définie dans une direction parallèle au vecteur *i̅* du repère orthogonal [*O;i̅;j̅;k̅*] donné sur la figure 2A) entre les électrodes 104 et 106. Le deuxième élément 113 permet de mettre en oeuvre une collecte plus rapide et plus efficace des électrons qu'avec une zone active uniquement à base de matériau 103 et mise en oeuvre suivant l'art antérieur.

Le premier élément 111 et le deuxième élément 113 peuvent être sous forme de zones allongées ou de pistes ou de barreaux, de longueurs respectives L₁ et L₂ comprises entre 10 nanomètres et 100 micromètres.

Dans l'exemple de la figure 2A, le premier élément 111 et le deuxième élément 113 s'étendent dans une direction réalisant un angle non-nul, en particulier de 90° avec les électrodes 104 et 106.

Le premier élément 111 comporte une extrémité 111a ou une zone située à proximité de l'anode 104 et espacée par exemple de l'anode d'une distance d₁(définie dans une direction parallèle au vecteur *i* du repère orthogonal [*O; i̅; j̅; k̅*]) qui peut être comprise par exemple entre plusieurs nanomètres et 10 micromètres.

Le premier élément 111 favorisant la conduction des trous est agencé de sorte à être davantage éloigné de la cathode 106 qu'il ne l'est de l'anode 104. Le premier élément 111 peut être éloigné de la cathode 104 d'une distance Δ₁ comprise par exemple entre 1 micromètre et 100 micromètres.

Selon une possibilité de mise en oeuvre, le premier élément 111 peut être éloigné de la cathode 104 d'une distance Δ₁ d'au moins dix fois la distance d₁, d₁ étant par exemple égal à 1 µm et Δ₁ égal à 10 µm, ou d₁ égal à 2 µm et Δ₁ égal à 20 µm.

Le deuxième élément 113 comporte quant à lui une extrémité ou une zone située à proximité de la cathode 106 et espacée par exemple de la cathode 106 d'une distance d₂ (définie dans une direction parallèle au vecteur *i̅* du repère orthogonal [*O; i̅; j̅;* *̅k̅*̅]̅) qui peut être comprise par exemple entre plusieurs nanomètres et 10 micromètres. Le deuxième élément 113 favorisant la conduction des électrons est agencé de manière à être davantage éloigné de l'anode 104 que de la cathode 106. Le deuxième élément 113 peut être situé à une distance Δ₂ de l'anode 104 comprise par exemple entre 1 micromètre et 100 micromètres.

Selon une possibilité de mise en oeuvre, le deuxième élément 113 peut être éloigné de l'anode 104 d'une distance Δ₂ d'au moins 10 fois d₂, d₂ étant par exemple égal à 1 µm et Δ₂ égal à 10 µm, ou d₂ étant égal à 2 µm tandis que Δ₂ est égal à 20 µm.

Le premier élément 111 n'est ni en contact avec l'électrode 104 ni en contact avec l'électrode 106. De même, le deuxième élément 113 n'est en contact avec aucune des électrodes 104, 106.

Afin de minimiser les phénomènes de réflexions, le premier élément 111 et le deuxième élément 113 peuvent être prévus avec une épaisseur mince vue par un rayonnement lumineux susceptible de pénétrer dans la zone active, inférieure ou égale à 100 nanomètres et avantageusement inférieure ou égale à 20 nanomètres. Dans cet exemple, l'épaisseur est une dimension différente de la dimension L₁ et est mesurée dans une direction orthogonale au vecteur *i̅,̅* lorsqu'un rayonnement est prévu pour pénétrer à travers une face de la zone active 102 parallèle au plan [O; *i̅*; *k̅*], et/ou lorsqu'un rayonnement est prévu pour pénétrer à travers une face de la zone active 102 parallèle au plan [O; *j̅; k̅*])*.*

Pour minimiser les phénomènes de réflexions, le premier élément 111 et le deuxième élément 113 peuvent être également prévus avec une surface susceptible d'être exposée à un rayonnement lumineux, au moins 10 fois inférieure à la surface de la zone active susceptible d'être exposée à ce rayonnement lumineux.

Le matériau 112 favorisant la conduction des trous peut être choisi de manière à avoir une conductivité σ₁ supérieure à la conductivité σ' par trous du ou des matériaux 103 de la zone active. La conductivité σ₁ du matériau 112 peut être avantageusement telle que σ₁ ≥ 2*σ'.

Selon une possibilité de mise en oeuvre, le matériau 112 favorisant la conduction des trous peut être un matériau semi-conducteur de type P, par exemple tel que du 6,13-bis(triisopropylsilylethynyl), TIPS pentacene, choisi de sorte que la mobilité µ₁ des trous dans ce matériau 112 est au moins 2 fois supérieure à la mobilité des trous dans le matériau 103 du reste de la zone active 102.

Le matériau 112 favorisant la conduction des trous peut être par exemple à base d'un matériau métallique tel que de l'Au, du Ni, du Pt, ou dé l'ITO (ITO pour « Indium Tin Oxide », ou oxyde d'indium dopé à l'étain) ou d'un semi-conducteur de type P tel que par exemple du Si dopé P.

Le matériau 112 peut être également un matériau ambipolaire tel que du Si dopé N et P.

Le matériau 112 peut être également un métal tel que par exemple de l'Au recouvert d'une couche SAM (SAM pour « self assembled monolayer »), prévue pour augmenter le travail de sortie dudit métal pour les trous, et qui peut être à base d'un polymère tel que du PFBT ou pentafluorobenzenethiol.

Le matériau 112 peut être également un polymère donneur d'électrons tel que du PEDOT poly(3,4-éthylènedioxythiophène).

Le matériau 114 favorisant la conduction des électrons peut, quant à lui, être choisi de manière à avoir une conductivité σ₂ supérieure à la conductivité σ par électrons du matériau 103 de la zone active 102. La conductivité σ₂ du matériau 114 favorisant la conduction des électrons peut être avantageusement telle que σ₂ ≥ 2*σ.

Selon une possibilité de mise en oeuvre, le matériau 114 favorisant la conduction des électrons peut être un matériau semi-conducteur de type N, par exemple tel que du diimide perylidène, ou ambipolaire tel que du Si dopé N et P, choisi de sorte que la mobilité µ₂ des électrons dans ce matériau 114 est au moins 2 fois supérieure à la mobilité des électrons dans le matériau 103 du reste de la zone active.

Le matériau 114 favorisant la conduction des électrons peut être par exemple à base d'un matériau métallique tel que de l'Al, du Cu, de l'ITO (ITO pour « Indium tin oxide »), ou d'un semi-conducteur de type N tel que par exemple du Si dopé N.

Le matériau 114 peut être également à base d'un métal tel que par exemple de l'Au qui peut être recouvert d'une couche SAM (SAM pour « self assembled monolayer ») prévue pour diminuer le travail de sortie du métal, et par exemple à base de 4 MTP ou 4-methylthiophenol.

Selon une autre possibilité, le matériau 114 peut être également à base d'un matériau Ambipolaire tel que par exemple du Si dopé N et P ou être à base d'un polymère accepteur d'électrons tel que du PSS poly(styrène sulfonate).

Selon une variante illustrée sur la figure 2B, la zone active 202 à base de polymère peut être formée d'une première région 202a à base d'un polymère donneur d'électrons accolée à une deuxième région 202b à base d'un polymère accepteur d'électrons.

Lorsque des photons sont absorbés par la couche active 202, des excitons ou paires électrons-trous sont généré(e)s puis dissocié(e)s. Le premier élément 111 permet de favoriser la conduction des trous vers l'anode 104, tandis que le deuxième élément 113 favorise la conduction des électrons vers la cathode 106.

Un autre exemple de photodiode organique mise en oeuvre suivant l'invention est donné sur la figure 3.

Dans cet exemple, un premier élément 211 en forme d'un peigne à deux branches ou d'un 'U' et à base du matériau 112 favorisant la conduction des trous est située dans la zone active 102 entre les électrodes 104 et 106, tandis qu'un deuxième élément 213 en forme de 'U' et à base d'un matériau 114 favorisant la conduction des électrons traverse également une partie de la zone active 102 entre les électrodes 104 et 106.

Le premier élément 211 comporte une zone 211a sous forme d'une piste située à proximité de l'anode 104 et s'étendant le long l'anode 104, et d'autres pistes 221b, 211c s'étendant en direction de la cathode 104. Le deuxième élément 213 comporte une zone 213a sous forme d'une piste située à proximité de l'anode 104 s'étendant le long de la cathode 106, et d'autres pistes 213b, 213c s'étendant en direction de l'anode 106.

L'agencement du premier élément 211 par rapport au deuxième élément 213 peut être tel qu'une piste 211b de ce dernier est disposée entre les pistes 213b, 213c du deuxième élément 213 qui s'étendent entre les électrodes, une piste 213a du deuxième élément 213 étant disposée entre les pistes 211b, 211c du premier élément 211 qui s'étendent entre les électrodes 104 et 106.

La zone active 102 comporte ainsi une alternance de pistes favorisant la conduction de trous et de pistes favorisant la conduction des électrons.

Un tel agencement permet de favoriser le transport des porteurs de charge tout en ayant un encombrement réduit.

Afin d'améliorer la collecte des charges, on peut augmenter le nombre d'éléments 211 et 213 dans le volume de la couche active 102. Sur la photodiode représentée sur la figure 4, la couche active 102 de matériau polymère comporte davantage d'éléments 211, 213 que sur le dispositif de la figure 3, et en particulier deux éléments 211 en forme de U et favorisant le transport des électrons, ainsi que deux autres éléments en forme de U favorisant le transport des trous.

Sur l'exemple de la figure 5, la photodiode comporte, dans le matériau de sa zone active 102, un premier élément 311 favorisant la conduction des trous et formé de pistes conductrices agencées en un premier peigne, ainsi qu'un deuxième élément 313 favorisant la conduction des électrons, et formé de pistes conductrices agencées en un deuxième peigne.

Le premier élément 311 comporte une piste longiligne 311a disposée à proximité et parallèlement à l'anode 104, et reliée à d'autres pistes 311b, 311c, 311d, 311e s'étendant en direction de la cathode 106, orthogonalement aux électrodes 104, 106.

Le deuxième élément 313 comporte une piste longiligne 313a disposée à proximité et parallèlement à la cathode 106, et reliée à d'autres pistes 313b, 313c, 313d, 313e s'étendant en direction de l'anode 106, orthogonalement aux électrodes 104, 106.

Le premier et le deuxième peignes sont interdigités, de sorte que des pistes 313b, 313c, 313d du deuxième élément 313 sont endentées entre des pistes du premier élément 311.

La figure 6 illustre une variante d'agencement, qui diffère de celui de la figure 5 de par l'orientation des éléments 311 et 313 sous forme de peigne.

Le premier élément 311 formant le premier peigne comporte une piste formant une dent de peigne s'étendant à proximité et parallèlement à l'anode 104, tandis que le deuxième élément 313 formant le deuxième peigne comporte une piste formant une dent de peigne s'étendant à proximité et parallèlement à la cathode 106.

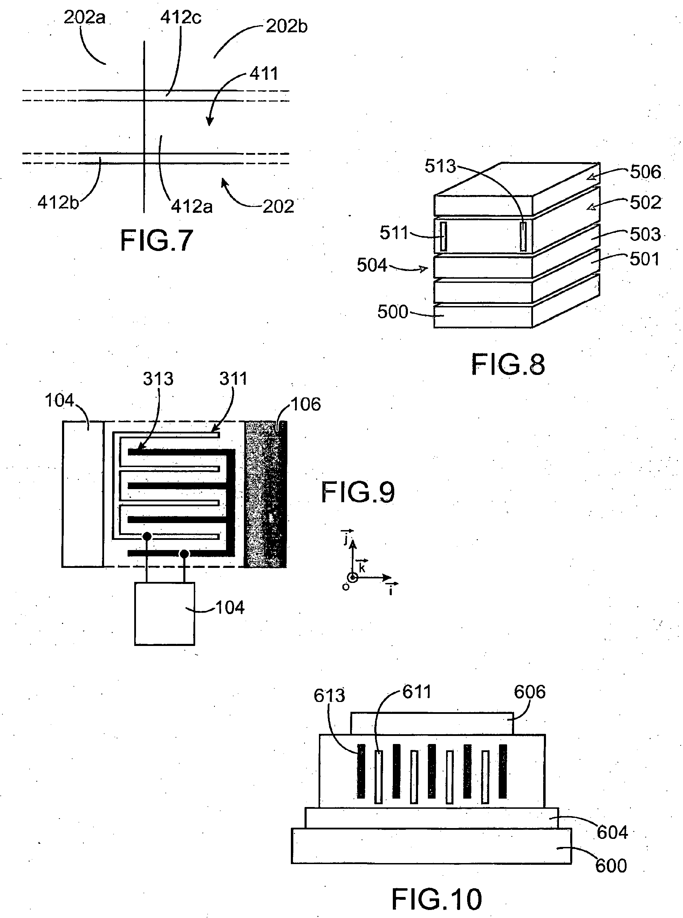

La figure 7 illustre un autre exemple de dispositif microélectronique suivant l'invention, comprenant une zone active 202 du type de celle du dispositif de la figure 3, située entre deux électrodes (non représentées) formée d'une première région 202a à base d'un polymère donneur d'électrons accolée à une deuxième région 202b à base d'un polymère accepteur d'électrons.

Des éléments 411 sont prévus dans la zone active 202 pour favoriser la collecte de porteurs de charge. Ces éléments 411 traversent la première région 202a et la deuxième région 202b et sont formés d'une zone de métal 412a recouverte dans ladite première région 202a d'une couche 412b adaptée pour augmenter le travail de sortie dudit métal pour les trous, la zone de métal 412a étant recouverte en outre dans ladite deuxième région 202b d'une autre couche 412c adaptée pour diminuer le travail de sortie dudit métal.

Les couches 412b, 412c peuvent être des couches de type SAM (SAM pour « self assembled monolayer ») la couche 412b peut être par exemple à base de perfluorobenzenethiol, tandis que la couche 412c peut être par exemple à base de 4-méthylthiophénol formée sur de l'Au.

Un exemple de réalisation en un empilement de couches d'une photodiode suivant l'invention est donné sur la figure 8.

Sur un substrat 500 qui peut être rigide et par exemple en verre, ou flexible et par exemple à base de polymère, on forme une première couche 501, par exemple à base d'ITO, destinée à former une anode 501 transparente. Puis, une autre couche 503 destinée à améliorer l'injection dans l'anode, par exemple à base de PEDOT-PSS et d'épaisseur par exemple de l'ordre de 50 nm, est formée sur la première couche 501.

On forme ensuite une couche active 502 qui peut être par exemple à base d'un mélange de PZZ et de PCBM dans un solvant. La couche active 502 peut être formée en plusieurs dépôts, par exemple par jet d'encre, ou dépôt à la tournette (« spin coating » selon la terminologie anglo-saxonne), ou dépôt communément appelé de type « doctor blading ».

Un premier dépôt de matériau actif peut être effectué sur la couche 503. Puis, un ou plusieurs éléments conducteurs ou semi-conducteurs 511 favorisant la conduction de trous dans le matériau actif sont formés. On effectue ensuite un deuxième dépôt de matériau actif, puis on réalise un ou plusieurs éléments conducteurs ou semi-conducteurs 513 favorisant la conduction d'électrons sur les couches déjà déposées de matériau actif. On effectue ensuite un autre dépôt de matériau actif pour recouvrir les éléments 513.

Ensuite, on forme une couche 506 destinée à former une cathode. La couche 506 peut être par exemple à base d'aluminium et d'épaisseur de l'ordre de 200 nm.

Le dispositif suivant l'invention peut être appliqué à une recharge d'un dispositif extérieur, par exemple un condensateur ou un accumulateur.

Sur l'exemple de la figure 9, la structure décrite précédemment en liaison avec la figure 5 est utilisée par exemple pour recharger un accumulateur.

Un premier élément 311 favorisant la conduction des trous et formé de pistes conductrices agencées en un premier peigne, est connecté à une première électrode de moyens 400 formant une charge, tandis qu'un deuxième élément 313 favorisant la conduction des électrons, et de pistes conductrices agencées en un deuxième peigne est connecté à une deuxième électrode des moyens 400. Dans cette configuration, les électrodes 104 et 106 de la photodiode son laissées flottantes et ne sont pas connectées à un autre dispositif.

La photodiode est placée sous un éclairement prévu de manière à créer des charges destinées à circuler jusqu'aux moyens 400. Les moyens 400 peuvent être par exemple sous forme d'au moins un condensateur ou d'au moins un accumulateur que l'on vient recharger à l'aide d'un courant généré dans la zone active et circulant dans les éléments 311, 313.

Sur la figure 10, un autre exemple de photodiode suivant l'invention est donné. Cette photodiode est formée sur un substrat 600 recouvert d'une cathode 604, surmontée d'une zone active 602 à base de matériau semi-conducteur inorganique par exemple à base d'oxyde de Ni et d'oxyde d'Indium, elle-même surmontée d'une anode 606.

Des éléments 611 favorisant la conduction des trous ainsi que des éléments 613 favorisant la conduction des électrons sont disposés dans la zone active 602 dans une direction verticale réalisant un angle non-nul aux électrodes s'étendant dans une direction horizontale.

## Revendications

1. Diode comprenant une zone active (102, 202) située entre une première électrode (104) et une deuxième électrode (106), la zone active étant formée d'au moins un matériau semi-conducteur, la diode étant **caractérisée en ce que** la zone active comporte en outre un ou plusieurs éléments conducteurs ou semi-conducteurs formés de zones allongées qui s'étendent entre les électrodes dans le matériau (103) de la zone active dans une direction réalisant un angle non-nul avec les électrodes, **caractérisé en ce que** les éléments ne sont pas connectés avec lesdites électrodes et **en ce que** parmi lesdits éléments un ou plusieurs premier(s) élément(s) (111, 211, 311) sont à base d'un premier matériau favorisant la conduction de trous, et un ou plusieurs deuxième(s) élément(s) (113, 213, 313) sont à base d'un deuxième matériau favorisant la conduction d'électrons,
le premier matériau est le deuxième matériau étant à base d'un matériau différent dudit matériau des régions de la zone active avéc laquelle lesdits premiers éléments et lesdits deuxièmes éléments sont en contact, ledit premier matériau ayant une conductivité par trous supérieure à la conductivité par trous dudit matériau (103) de la zone active, et/ou ledit deuxième matériau favorisant la conduction des électrons ayant une conductivité supérieure à la conductivité par électrons dudit matériau (103) de la zone active.

2. Diode selon la revendication 1, la zone active étant formée d'au moins un matériau polymère semi-conducteur.

3. Diode selon l'une des revendications 1 ou 2, lesdits éléments étant à base d'un matériau présentant une meilleure conductivité que ledit matériau semi-conducteur de la zone active.

4. Diode selon l'une des revendications 1 à 3, dans laquelle lesdits éléments sont à base d'un matériau dans lequel la mobilité des porteurs de charge est au moins deux fois supérieure à la mobilité des porteurs de charge dans ledit au moins un matériau semi-conducteur de la zone active.

5. Diode selon l'une des revendications 1 à 4, dans laquelle au moins un desdits éléments (111, 113, 211, 213, 311, 313) est à base d'un matériau polymère conducteur.

6. Diode selon l'une des revendications 1 â 4, dans laquelle au moins un desdits éléments (111, 113, 211, 213, 311, 313) est à base d'un matériau ambipolaire.

7. Diode selon l'une des revendications 1 à 3, dans laquelle parmi lesdits éléments figurent :
- un ou plusieurs premier(s) élément(s) à base d'un matériau conducteur de type P, choisi parmi les matériaux suivants : Au, ITO, Cu, Ni, Ag, Pd, PDOT:PSS,
- un ou plusieurs deuxième(s) élément(s) à base d'un matériau conducteur de type N, choisi parmi les matériaux suivants : Ca, Al.

8. Diode selon l'une des revendications 1 à 3, dans laquelle au moins un desdits éléments est à base d'un métal recouvert d'une couche adaptée pour modifier le travail de sortie dudit métal.

9. Diode selon la revendication 8, dans laquelle parmi lesdits éléments conducteurs ou semi-conducteurs peuvent également figurer :
- un ou plusieurs premier(s) élément(s) à base d'un métal recouvert d'une couche SAM de type P à base de PFBT ou pentafluorobenzenethiol,
et/ou,
- un ou plusieurs premier(s) élément(s) à base d'un métal recouvert d'une couche SAM de type N à base de 4MTP ou méthoxythiolphenol

10. Diode selon la revendication 8 ou 9, dans laquelle ladite zone active est formée d'une première région (202a) à base dudit premier matériau polymère et d'une deuxième région (202b) accolée à la première région et à base dudit deuxième matériau polymère, au moins un desdits éléments étant à base d'une zone de métal traversant la première région et la deuxième région, la zone de métal étant recouverte dans ladite première région d'une première couche adaptée pour augmenter le travail de sortie dudit métal, la zone de métal étant recouverte en outre dans ladite deuxième région d'une autre couche adaptée pour diminuer le travail de sortie dudit métal.

11. Diode selon l'une des revendications 1 à 10, dans laquelle la zone active (102) est formée d'un mélange d'un premier matériau polymère et d'un deuxième matériau polymère.

12. Diode selon l'une des revendications 1 à 10, dans laquelle la zone active (102) est formée d'un mélange de PCBM et de P3HT.

13. Diode selon l'une des revendications 1 à 12, dans laquelle les éléments (111, 211, 311, 113, 213, 313) sont formés d'un ensemble de pistes (211b, 211c, 213b, 213c, 311b, 311c, 311d, 311e, 313b, 313e, 313d, 313e), l'agencement desdits éléments dans la zone active (102) formant une alternance de pistes favorisant la conduction de trous et da pistes favorisant la conduction des électrons.

14. Diode selon la revendication 13, dans laquelle les pistes (313b, 313c, 313d, 313e) favorisant la conduction des électrons et les pistes (311b, 311c, 311d, 311e) favorisant la conduction des trous sont disposées sous forme de peignes interdigitès.

15. Diode selon l'une des revendications 1 à 14, dans laquelle la première électrode joue le rôle d'anode et la deuxième électrode joue le rôle de cathode, le ou les éléments (111) favorisant la conduction de trous étant disposés plus prêt de la cathode que de l'anode, les éléments (113) favorisant la conduction des électrons étant disposés plus prêt de l'anode que de la cathode.

16. Diode selon la revendication 15, le ou les éléments (111) favorisant la conduction de trous étant disposés à une distance d₁ de la cathode et d'une distance Δ₁ de l'anode, avec d₁/Δ₁ ≤ 10, et/ou le ou les éléments (113) favorisant la conduction des électrons étant disposés à une distance d'au plus d₂ de l'anode et d'au moins Δ₂ de la cathode, avec d₂/Δ₂ ≤ 10.

17. Diode selon l'une des revendications 1 à 16, dans lequel lesdits éléments (111, 113) conducteurs ou semi-conducteurs ont une surface totale susceptible d'être vue par un rayonnement lumineux au moins 10 fois inférieure à la surface de la zone active vue par ce même rayonnement lumineux.

18. Diode selon l'une des revendications 1 à 17, dans lequel lesdits éléments (111, 113) conducteurs ou semi-conducteurs ont une épaisseur inférieure à 100 nanomètres.

19. Dispositif microélectronique comprenant au moins une diode selon l'une des revendications 1 à 18, lesdits éléments conducteurs (111, 113) étant connectés à une charge telle qu'un accumulateur ou un condensateur.

## Patentansprüche

1. Diode mit einer aktive Zone (102, 202), die zwischen einer ersten Elektrode (104) und einer zweiten Elektrode (106) liegt, wobei die aktive Zone aus zumindest einem Halbleitermaterial gebildet ist, wobei die Diode **dadurch gekennzeichnet ist, dass** die aktive Zone ferner ein oder mehrere Leiter- bzw. Halbleiterelemente aufweist, die aus länglichen Bereichen gebildet sind, die sich zwischen den Elektroden in dem Material (103) der aktiven Zone in einer Richtung erstrecken, die mit den Elektroden einen Winkel ungleich null einschließt, **dadurch gekennzeichnet, dass** die Elemente nicht mit den Elektroden verbunden sind und dass unter den Elementen ein oder mehrere erste(s) Element(e) (111, 211, 311) auf Basis von einem ersten Material bestehen, das die Löcherleitung begünstigt, und ein oder mehrere zweite(s) Element(e) (113, 213, 313) auf Basis von einem zweiten Material bestehen, das die Elektronenleitung begünstigt,
wobei das erste Material und das zweite Material auf Basis von einem Material bestehen, das sich von dem Material der Bereiche der aktive Zone unterscheidet, mit dem die ersten Elemente und die zweiten Elemente in Kontakt stehen, wobei das erste Material eine Löcherleitfähigkeit aufweist, die höher als die Löcherleitfähigkeit des Materials (103) der aktiven Zone ist, und/oder das die Elektronenleitung begünstigende zweite Material eine Leitfähigkeit hat, die höher als die Elektronenleitfähigkeit des Materials (103) der aktive Zone ist.

2. Diode nach Anspruch 1, wobei die aktive Zone aus zumindest einem Halbleiter-Polymermaterial gebildet ist.

3. Diode nach einem der Ansprüche 1 oder 2, wobei die Elemente auf Basis von einem Material bestehen, das eine bessere Leitfähigkeit als das Halbleitermaterial der aktive Zone aufweist.

4. Diode nach einem der Ansprüche 1 bis 3, wobei die Elemente auf Basis eines Materials bestehen, in welchem die Beweglichkeit der Ladungsträger zumindest zweimal so hoch ist wie die Beweglichkeit der Ladungsträger in dem zumindest einen Halbleitermaterial der aktive Zone.

5. Diode nach einem der Ansprüche 1 bis 4, wobei zumindest eines der Elemente (111, 113, 211, 213, 311, 313) auf Basis von einem leitfähigen Polymermaterial besteht.

6. Diode nach einem der Ansprüche 1 bis 4, wobei zumindest eines der Elemente (111, 113, 211, 213, 311, 313) auf Basis von einem ambipolaren Material besteht.

7. Diode nach einem der Ansprüche 1 bis 3, wobei unter den Elementen vorkommen:
- ein oder mehrere erste(s) Element(e) auf Basis von einem leitfähigen Material vom Typ P, das ausgewählt ist aus folgenden Materialien: Au, ITO, Cu, Ni, Ag, Pd, PDOT:PSS,
- ein oder mehrere zweite(s) Element(e) auf Basis von einem leitfähigen Material vom Typ N, das ausgewählt ist aus folgenden Materialien: Ca, Al.

8. Diode nach einem der Ansprüche 1 bis 3, wobei zumindest eines der Elemente auf Basis von einem Metall besteht, das mit einer Schicht überzogen ist, die dazu geeignet ist, die Austrittsarbeit des Metalls zu verändern.

9. Diode nach Anspruch 8, wobei unter den Leiter- bzw. Halbleiterelementen auch vorkommen können:
- ein oder mehrere erste(s) Element(e) auf Basis von einem Metall, das mit einer SAM-Schicht vom Typ P auf Basis von PFBT oder Pentafluorbenzenethiol überzogen ist,
und/oder
- ein oder mehrere erste(s) Element(e) auf Basis von einem Metall, das mit einer SAM-Schicht vom Typ N auf Basis von 4MTP oder Methoxythiolphenol überzogen ist.

10. Diode nach Anspruch 8 oder 9, wobei die aktive Zone aus einem ersten Bereich (202a) auf Basis vom ersten Polymermaterial und aus einem zweiten Bereich (202b) gebildet ist, der an den ersten Bereich angefügt ist und auf Basis von dem zweiten Polymermaterial besteht, wobei zumindest eines der Elemente auf Basis von einem Metallbereich besteht, der sich durch den ersten Bereich und den zweiten Bereich erstreckt, wobei der Metallbereich in dem genannten ersten Bereich mit einer ersten Schicht überzogen ist, die dazu geeignet ist, die Austrittsarbeit des Metalls zu erhöhen, wobei der Metallbereich ferner in dem zweiten Bereich mit einer weiteren Schicht überzogen ist, die dazu geeignet ist, die Austrittsarbeit des Metalls zu vermindern.

11. Diode nach einem der Ansprüche 1 bis 10, wobei die aktive Zone (102) aus einem Gemisch aus einem ersten Polymermaterial und einem zweiten Polymermaterial gebildet ist.

12. Diode nach einem der Ansprüche 1 bis 10, wobei die aktive Zone (102) aus einem Gemisch aus PCBM und P3HT gebildet ist.

13. Diode nach einem der Ansprüche 1 bis 12, wobei die Elemente (111, 211, 311, 113, 213, 313) aus einer Gruppe von Bahnen (211 b, 211 c, 213b, 213c, 311b, 311c, 311 d, 311e, 313b, 313c, 313d, 313e) gebildet sind, wobei die Anordnung der Elemente in der aktiven Zone (102) eine Wechselfolge von die Löcherleitung begünstigenden Bahnen und die Elektronenleitung begünstigenden Bahnen bildet.

14. Diode nach Anspruch 13, wobei die Bahnen (313b, 313c, 313d, 313e), die die Elektronenleitung begünstigen, und die Bahnen (311b, 311c, 311 d, 311e), die die Löcherleitung begünstigen, in Form von interdigitalen Kämmen angeordnet sind.

15. Diode nach einem der Ansprüche 1 bis 14, wobei die erste Elektrode die Rolle der Anode spielt und die zweite Elektrode die Rolle der Kathode spielt, wobei das bzw. die Elemente (111), die die Löcherleitung begünstigen, näher an der Kathode als an der Anode angeordnet sind, wobei die die Elektronenleitung begünstigenden Elemente (113) näher an der Anode als an der Kathode angeordnet sind.

16. Diode nach Anspruch 15, wobei die die Löcherleitung begünstigenden Elemente (111) in einer Entfernung d₁ von der Kathode und in einer Entfernung Δ₁ von der Anode angeordnet sind, mit d₁/Δ₁ ≤ 10, und/oder die die Elektronenleitung begünstigenden Elemente (113) in einer Entfernung von höchstens d₂ von der Anode und von mindestens Δ₂ von der Kathode angeordnet sind, mit d₂/Δ₂ ≤ 10.

17. Diode nach einem der Ansprüche 1 bis 16, wobei die Leiter- bzw. Halbleiterelemente (111, 113) eine Gesamtfläche haben, die von einer Lichtstrahlung getroffen werden kann, die mindestens zehnmal so gering wie die Fläche der aktiven Zone ist, die von dieser gleichen Lichtstrahlung getroffen wird.

18. Diode nach einem der Ansprüche 1 bis 17, wobei die Leiter- bzw. Halbleiterelemente (111, 113) eine Dicke von unter 100 Nanometer haben.

19. Mikroelektronische Vorrichtung mit zumindest einer Diode nach einem der Ansprüche 1 bis 18, wobei die Leiterelemente (111, 113) mit einer Last, wie etwa einem Akkumulator oder einem Kondensator, verbunden sind.

## Claims

1. Diode comprising an active zone (102, 202) located between a first electrode (104) and a second electrode (106), the active zone being formed from at least one semiconducting material, the diode being **characterised in that** the active zone further comprises one or several conducting or semiconducting elements formed from elongated conducting zones that extend between the electrodes in the material (103) of the active zone along a direction forming a non-zero angle with the electrodes, **characterised in that** the elements are not in contact with the electrodes and that among said elements, one or plural first elements are based on a first material promoting conduction of holes, and one or plural second elements are based on a second material promoting conduction of electrons,
the first material and the second material being based on a material that is different from said material of regions of the active zone with which said first elements and said second elements are in contact, the first material having a hole conductivity higher than the conductivity of holes of said material (103) in the active zone, and/or the second material promoting conduction of electrons having a conductivity exceeding the electron conductivity of said material (103) of the active zone.

2. Diode according to claim 1, the active zone being formed from at least one semiconducting polymer material.

3. Diode according to any of claims 1 or 2, said elements being based on a material with better conductivity than said semiconducting material in the active zone.

4. Diode according to any of claims 1 to 3, wherein said elements are based on a material in which the mobility of charge carriers is at least twice as high as, the mobility of charge carriers in said at least one semiconducting material in the active zone.

5. Diode according to any of claims 1 to 4, in which at least one of said elements (111, 113, 211, 213, 311, 313) is based on a conducting polymer material.

6. Diode according to any of claims 1 to 4, in which at least one of said elements (111, 113, 211, 213, 311, 313) is based on an ambipolar material.

7. Diode according to any of claims 1 to 3, in which said elements include:
- one or several element(s) based on a P type conducting material, chosen from among the following materials: Au, ITO, Cu, Ni, Ag, Pd, PDOT:PSS,
- one or several second element(s) based on an N type conducting material, chosen from among the following materials: Ca, Al.

8. Diode according to any of claims 1 to 3, in which at least one of said elements is based on a metal covered with a layer capable of modifying the work function of said metal.

9. Diode according to claim 8, in which said conducting or semiconducting elements may also include:
- one or several first element(s) based on a metal covered by a P type SAM layer based on PFBT or pentafluorobenzenethiol,
and/or,
- one or several first element(s) based on a metal covered by an N type SAM layer based on 4MTP or methoxythiolphenol.

10. Diode according to claim 8 or 9, in which said active zone is formed from a first region (202a) based on said first polymer material and a second region (202b) adjacent to the first region and based on said second polymer material, at least one of said elements being based on a metal zone passing through the first region and the second region, the metal zone being covered in said first region by a layer capable of increasing the work function of said metal, the metal zone being also covered in said second region with a layer capable of reducing the work function of said metal.

11. Diode according to one of claims 1 to 10, in which the active zone (102) is formed from a mix of a first polymer material and a second polymer material.

12. Diode according to any of claims 1 to 10, in which the active zone (102) is formed from a mix of PCBM and P3HT.

13. Diode according to one of claims 1 to 12, wherein elements (111, 211, 311, 113, 213, 313) are formed from a set of tracks (211b, 211c, 213b, 213c, 311b, 311c, 311d, 311e, 313b, 313c, 313d, 313e), the arrangement of said elements in the active zone (102) forming alternating tracks promoting conduction of holes and tracks promoting conduction of electrons.

14. Diode according to claim 13, in which tracks (313b, 313c, 313d, 313e) promoting conduction of electrons and tracks (311b, 311c, 311d, 311e) promoting conduction of holes are arranged in the form of interdigitated combs.

15. Diode according to any of claims 1 to 14, in which the first electrode acts as an anode and the second electrode acts as a cathode, element(s) (111) promoting conduction of holes being arranged closer to the cathode than to the anode, elements (113) promoting conduction of electrons being arranged closer to the anode than to the cathode.

16. Diode according to claim 15, elements (111) promoting conduction of holes are arranged at a distance d₁ from the cathode and a distance Δ₁ from the anode, in which d₁/Δ₁ ≤ 10, and/or elements (113) promoting conduction of electrons are arranged at a distance not more than d₂ from the anode and at least Δ₂ from the cathode, in which d₂/Δ₂ ≤ 10.

17. Diode according to any of claims 1 to 16, in which said conducting or semiconducting elements (111, 113) have a total surface area that can be exposed to light radiation at least 10 times smaller than the surface area of the active zone exposed to this radiation.

18. Diode according to any of claims 1 to 17, in which said conducting or semiconducting elements (111, 113) have a thickness less than 100 nanometres.

19. Microelectronic device comprising at least one diode according to any of claims 1 to 18, said conducting elements (111, 113) being connected to a load in the form of an accumulator or a capacitor.
